# EUROPEAN PATENT APPLICATION

(11) **EP 4 803 913 A1**
(43) Date of publication of application: **09.09.2026**
(21) Application number: 25161369.1
(22) Date of filing: 03.03.2025
(51) Int. Cl.: G01R 31/367, G01R 31/392

(54) **METHOD, APPARATUS AND SYSTEM FOR ESTIMATING A STATE OF HEALTH OF A BATTERY**

(71) Applicant: ABB SCHWEIZ AG, 5400 Baden (CH)
(72) Inventor: MATTOLIN, Giulio, 6593 Cadenazzo (CH); BRIOSCHI, Massimiliano, 6648 Minusio, TI (CH)
(74) Representative: Maiwald GmbH

(57) **Abstract**

The invention relates to a method for estimating an SoH of a battery comprising the steps: discharging a Field Battery; measuring electrical battery parameters of the Field Battery during discharging, collecting measuring data of the Field Battery, and determining a Field Battery measuring discharge curve; estimating Healthy Discharge Curve of Field Battery using a neural network trained with measuring data of electrical battery parameters of a Reference Battery collected during discharging a Reference Battery to predict a Healthy Discharge Curve; comparing the estimated Healthy Discharge Curve of the Field Battery with the measuring discharge curve of the Field Battery; if a value of the measuring discharge curve of the Field Battery is smaller than a value of the estimated Healthy Discharge Curve of the Field Battery at a distinct point of time, determining the time difference between the distinct point of time and a predicted point of time, when the value is estimated to be reached according to the prediction of the neural network; estimating an SoH of the Field Battery based on the difference between the distinct point of time and the predicted point of time.

## Description

### Technical Field

The invention relates to a method for estimating an State of Health (SoH) of a battery, and an SoH estimating system, a method for training a neural network to predict a Healthy Discharge Curve of battery, a data processing apparatus comprising means for carrying out the methods, a computer program and a computer-readable storage medium.

### Background

Estimating the State of Health (SoH) is imperative for ensuring the safe, reliable, and efficient operation of batteries, which are vital to various applications, including energy storage systems, electric vehicles, and portable electronic devices. As batteries age, they undergo degradation in capacity and power, which can have a substantial impact on their performance and lifespan. In the context of, for example, Uninterruptible Power Supplies (UPS), the estimation of the SoH for batteries is a critical task that ensures their ability to provide backup power during outages and prevent unexpected downtime. Regular monitoring of SoH allows informed decisions about battery replacements to be made, avoiding unnecessary expenses and reducing long-term costs. Understanding the health of batteries enhances asset management and allows businesses to plan for future investments and upgrades. Additionally, batteries in poor health can pose safety risks, and thus monitoring the SoH helps in identifying potential safety issues early.

Traditionally, SoH estimation methods are categorized into direct methods and indirect methods, each with its own set of challenges. Direct measurement methods, such as capacity testing and impedance spectroscopy, are effective in controlled laboratory conditions, but are impractical for real-time applications due to their complexity and the need for high-precision sensors. Furthermore, implementation of these methods would necessitate the interruption of normal battery operation, a process that is not feasible for uninterruptible power supply (UPS) systems designed to provide continuous power. Conversely, indirect analytical techniques, such as differential analysis and model-based methods, offer a more practical solution for real-time estimation. However, these techniques require extensive and time-consuming tests to build accurate, well-parameterized models and specific test conditions, such as constant current charging/discharging at low rates.

### Summary of the invention

There may be a desire to provide an improved and cost-effective method for estimating an SoH of a battery.

The problem is solved by the subject-matter of the independent claims. Embodiments are provided by the dependent claims, the following description and the accompanying figures.

The described embodiments similarly pertain to the method for estimating an SoH of a battery, the SoH estimating system, the method for training a neural network to predict a Healthy Discharge Curve of battery, the data processing apparatus comprising means for carrying out the methods, the computer program and the computer-readable storage medium. Synergetic effects may arise from different combinations of the embodiments although they might not be described in detail.

Further on, it shall be noted that all embodiments of the present invention concerning a method might be carried out with the order of the steps as described, nevertheless this has not to be the only and essential order of the steps of the method. The herein presented methods can be carried out with another order of the disclosed steps without departing from the respective method embodiment, unless explicitly mentioned to the contrary hereinafter.

Technical terms are used by their common sense. If a specific meaning is conveyed to certain terms, definitions of terms will be given in the following in the context of which the terms are used.

According to a first aspect, a method for estimating an SoH of a battery comprising the following steps. A Field Battery is discharged, the electrical battery parameters of the Field Battery are measured during discharging, and the measuring data of the Field Battery are collected. A Field Battery measuring discharge curve is determined based on the collected measuring data. A Healthy Discharge Curve of the Field Battery is determined using a neural network trained with measuring data of electrical battery parameters of a Reference Battery collected during discharging a Reference Battery. The estimated Healthy Discharge Curve of the Field Battery is compared with the measuring discharge curve of the Field Battery. If a value of the measuring discharge curve of the Field Battery is smaller than a value of the estimated Healthy Discharge Curve of the Field Battery at a distinct point of time, the time difference between the distinct point of time and a predicted point of time, when the value is estimated to be reached according to the prediction of the neural network is determined. Finally, an SoH of the Field Battery is estimated based on the difference between the distinct point of time and the predicted point of time.

A Reference Battery is preferably a new battery and is preferably of the same type, model and capacity, preferably with a State of Health (SoH) of 100%. The Field Battery is the battery under test, e.g. a battery which is currently used in a vehicle, a UPS system, in a mobile phone, in a wireless headphone, etc. with an unknown SoH. The temperature is an environment temperature in close proximity to the battery and the load is equivalent to a discharge current. The temperature and load are preferably in ranges that are typical for an application and can be chosen arbitrarily, or for example in pre-defined intervals. For example, the temperature could be chosen in 1°, 5° or 10° intervals and the output load in 10 A, 20 A, or 100 A intervals. The intervals can also be chosen to be non-linear. The Healthy Discharge Curve of the Field Battery is the Discharge Curve of the Field Battery which would be expected based on the Reference Battery for this battery at the conditions, i.e., temperature and load, that are nearest to the conditions at which its discharge is conducted. Instead of determining the difference between the points of time, the points of time can be used directly to, for example, relate these points of time to each other. The skilled person is aware of such basic methods.

According to an embodiment, the measuring data with which the neural network is trained comprises data of the following parameters: Battery voltage, environment temperature, and output load, wherein the neural network has been trained by discharging sessions in which the environment temperature and/or the output load have been varied.

According to an embodiment, the Healthy Discharge Curve of the Field Battery and the measuring discharge curve each represent a battery voltage over time.

According to an embodiment, the Healthy Discharge Curve comprises a main curve and a confidence interval, and the predicted point of time is a point of time at the edge of the confidence interval.

The confidence interval may be considered as a time interval that comprises a point of the main curve. That is, if the voltage is plotted over time in a coordinate system, then the confidence interval can be seen in the direction of the x-axis, i.e. the time axis. The point of time of the estimated Healthy Discharge Curve, which may then be chosen is the point of time of this interval, which is nearest to the distinct point of time of the measured discharge curve of the Field Battery.

According to a second aspect, a method for training a neural network configured to predict a Healthy Discharge Curve of battery is provided. The method comprises the following steps: In a first step, training data is obtained during a plurality of discharges of a Reference Battery comprising battery voltage, temperature and output load; wherein temperature and output load are varied at each discharge. In a second step, training the neural network based on the training data to predict a Healthy Discharge Curve.

The neural network trained in this way may be used for the method for estimating an SoH of a battery as described above.

In this context, obtaining is understood as receiving or determining. The measurement data may be collected and stored in a memory beforehand, and the data stored in the memory is input to the neural network. Alternatively, the measurement data a fed into the neural network during the discharging, i.e. during the measurement.

According to an embodiment, the measuring data for training the neural network is smoothed.

The measuring data before processing such as smoothing or filtering is also referred to as raw measuring data in this disclosure.

According to an embodiment, the number of discharges for training is artificially augmented by adding a noise voltage to the smoothed measuring data

According to an embodiment, the Reference Battery is a new and unused battery of same type and same model as the battery under test, and with 100% SoH.

According to a further aspect, an SoH estimating system is provided. The SoH estimating system comprises an electrical battery parameter measuring interface configured to receive measurements of electrical battery parameters of a Field Battery, and a data processing apparatus as described herein, wherein the data processing apparatus is communicatively connected to the electrical battery parameter measuring interface.

According to an embodiment, the SoH estimating system further comprises a measurement device configured to perform electrical battery parameter measurements of the Reference Battery during discharging, and to perform electrical battery parameter measurements of the Field Battery during discharging.

The proposed method introduces a Machine Learning (ML) based method to monitor the aging of batteries and estimate their SoH. It allows to estimate the SoH using data coming from basic mandatory sensors, namely temperature, voltage and output load sensors, and requires a limited amount of experimental data to create the training dataset. Moreover, it does not require historical data of the Field Battery, so that it can be directly applied to the existing set of batteries in the field, and it can be run and updated from remote, without the need for manual intervention in case the measurement device is already connected to the cloud. The proposed method is not part of the direct methods. Therefore, it does not require invasive procedures to measure the degradation of battery, nor the use of specialized equipment, nor the interruption of battery normal operations. Furthermore, it differentiates from existing indirect methods, since it does not require extensive and time-consuming experimental test, nor specific battery conditions, nor specialized sensors. Moreover, it differentiates from existing ML methods, since it does not require large amounts of labeled aging data for training, which is time-consuming and expensive to collect.

According to a third aspect, an alternative method for estimating an SoH of a battery comprising the following steps:
In a first step, a combination out of a set of N combinations of temperature and load at which a Reference Battery is to be discharged is selected. Then, a loop is performed that includes the following steps: In a first loop step, a Reference Battery is discharged at the selected combination of temperature and load. In a second loop step, electrical battery parameters of the Reference Battery are measured during discharging and the measuring data of the Reference Battery are collected. In a third loop step, a Healthy Discharge Curve (HDC) of the Field Battery is determined from the collected measuring data of the Reference Battery and stored. These loop steps of the loop cycle are repeated for the remaining N-1 combinations. After finishing the loop, the Field Battery is discharged, and electrical battery parameters of the Field Battery are measured during discharging. The measuring data of the Field Battery is collected, and a Field Battery measuring discharge curve is determined based on the collected measuring data. In a next step, a Healthy Discharge Curve for the Field Battery is estimated by selecting the discharge curve obtained from the Reference Battery at the closest combination of temperature and load to that measured by the Field Battery during discharge. In a next step of the method, the estimated Healthy Discharge Curve (HDC) of the Field Battery is compared with the measured discharge curve of the Field Battery. If a value of the measuring discharge curve of the Field Battery is smaller than a value of the estimated Healthy Discharge Curve of the Field Battery at a distinct point of time of the measurement, the time difference between the distinct point of time and a point of time according to the Healthy Discharge Curve determined. Finally, the SoH of the Field Battery is estimated based on the difference between the distinct point of time and the point of time according to the Healthy Discharge Curve. Thereby, the relation between the two points of time is that the respective Discharge Curves show the same voltage at these points of time.

Of course, the SoH can be corrected, e.g., by interpolation or extrapolation or adding a positive or negative value to the SoH value. For example, if the temperature at which the Field Battery is measured, is in between a first and a second temperature of the HDC, the two respective predicted points of time can be determined and a linear of non-linear interpolation of these values can be applied as correction value. The same applies to the load. Algorithms of multivariate optimization may be applied.

These and other features, aspects and advantages of the present invention will become better understood with reference to the accompanying figures and the following description.

### Short Description of the Figures

- Fig. 1a: shows a flow diagram for collecting data used as training data for the neural network.
- Fig. 1b: shows a flow diagram for training the neural network.
- Fig. 1c: shows a flow diagram for estimating the SoH of a Field Battery.
- Fig. 2: shows a plot of raw discharge curves.
- Fig. 3: shows a plot of smoothed discharge curves.
- Figs. 4a - 4e: illustrate the augmentation of discharge curves.
- Fig. 5: shows a diagram illustrating the steps of the method.
- Fig. 6a: shows a complete field discharge curve at 100% SoH.
- Fig. 6b: shows the corresponding HDC in the case of 100% SoH.
- Fig. 7a: shows a partial field discharge curve at 100% SoH.
- Fig. 7b: shows the corresponding HDC in the case of 100% SoH.
- Fig. 8a: shows a complete field discharge curve at <100% SoH.
- Fig. 8b: shows the corresponding HDC in the case of <100% SoH.
- Fig. 9a: shows a partial field discharge curve at <100% SoH.
- Fig. 9b: shows the corresponding HDC in the case of <100% SoH.
- Fig. 10: shows a flow diagram of an alternative method for estimating the SoH of a Field Battery.
- Fig. 11: shows a block diagram of an SOH estimating system.

### Detailed Description of Embodiments

Corresponding parts are provided with the same reference symbols in all figures.

Methods for estimating an SoH of a Field Battery, e.g. a battery that is or was in use, e.g. in an UPS application or electrical vehicle application are presented. A neural network is trained to learn the relationship between the temperature, output load and voltage from a limited amount of data, obtained by performing discharges of a Reference Battery, for an example a battery that may be referred to as New Lab Battery (NLB) at different loads and temperatures. The neural network is trained to predict the Healthy Discharge Curve (HDC). The HDC is then applied to a Field Battery and compared to a measured Field Battery discharge curve. When a Field Battery (FB) performs a discharge, the neural network predicts the HDC considering the actual load and temperature. The predicted HDC is then used to estimate the SoH of FB. When the FB performs a discharge, it is possible to monitor its discharge curve, namely the Field Discharge Curve (FDC), and compare it with the predicted HDC based on the actual load and temperature sustained by FB. By measuring the discrepancy between HDC and FDC, it is then possible to estimate the SoH of FB.

Further, an alternative solution is provided to estimate the SoH of a Field Battery without use of a neural network.

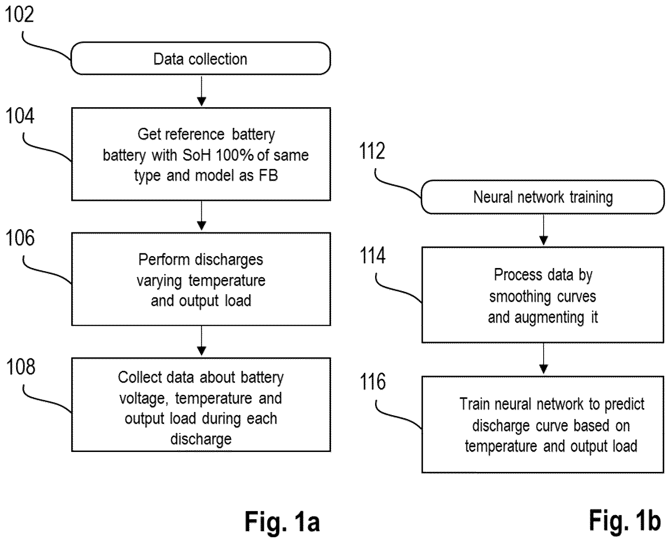

Figs. 1a to 1c show three flow diagrams related to the method for estimating an SoH using a neural network. The three flow diagram show the steps for collecting data, training the neural network and estimating the SoH.

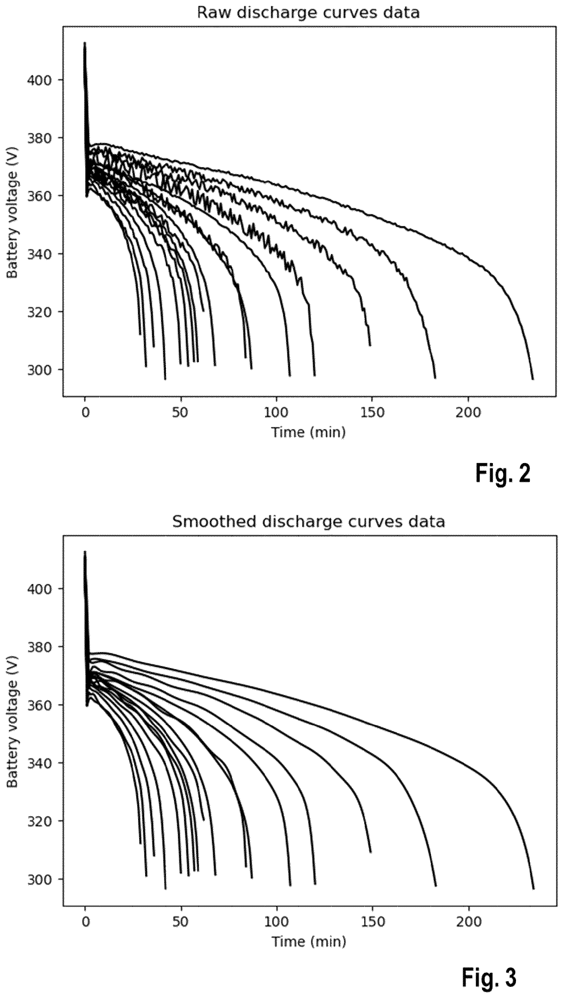

Fig. 1a shows a flow diagram with steps for collecting 102 data used as training data for the neural network. In step 104, a battery with SoH 100% and which is of same type and model and which has the same capacity as the Field Battery is selected for use as Reference Battery provided. In step 106 discharges are performed repeatedly. The discharges start preferably with a fully charged battery. That is, the battery is recharged before the next discharge. The temperature and/or the output load, i.e. the output current, is varied for each of the discharges. In 108 the data with battery voltage, temperature and output load is collected, e.g. as data sets comprising the raw data, during each discharge. The data may be stored, for example, in a memory. Fig. 2 shows examples of curves of a Reference Battery plotted based on raw data collected during the discharges. The discharge curves are plotted as battery voltage [V] over time [min.]. The battery voltage interval on the x-axis in the plots is 300 V to 420 V and the time interval on the y-axis is 0 to 90 minutes. The discharge curves of the Reference Battery vary in dependence on the output load and the temperature.

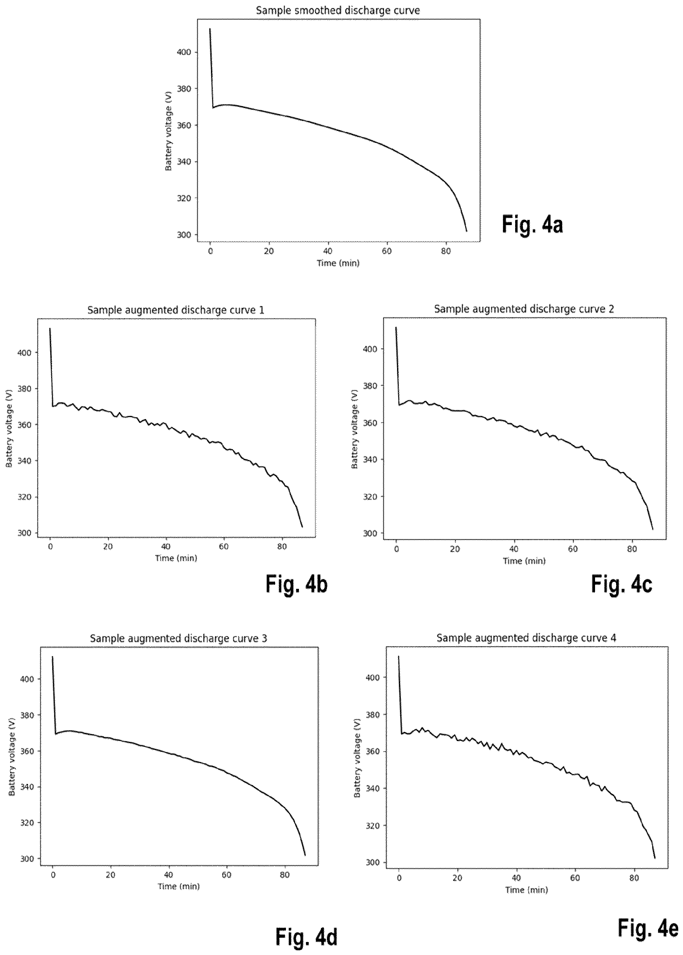

Fig. 1b shows a flow diagram with steps for training 112 the neural network. In step 112, the raw data process data by smoothing discharge curves and augmenting them. Fig. 3 shows as an example the smoothed discharge curves based on the raw data curves of Fig. 2. Fig. 4a shows one of the smoothed discharge curves of Fig. 3 from which further discharge curves are generated artificially as augmentation, and Figs. 4b to 4e show examples of generated augmentation discharge curves based on the smoothed discharge curve of Fig. 4a. The augmentation discharge curves may be generated for example by adding a signal, such as a noise, e.g. gaussian noise, or a pseudo-noise signal to a smoothed discharge curve.

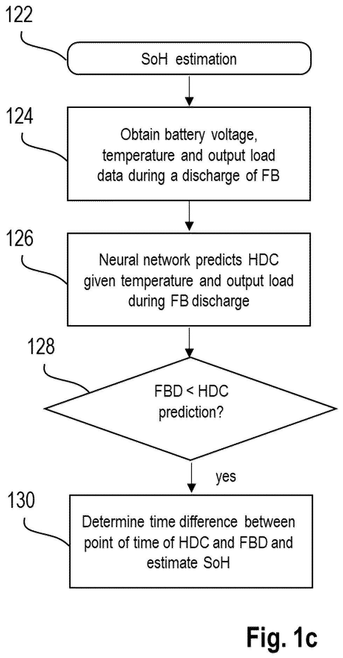

Fig. 1c shows a flow diagram with steps for estimating 122 the SoH of a Field Battery using the neural network trained as shown in Fig. 1b. In step 124, temperature and output load data is obtained during a discharge of FB. In step 126, the neural network predicts the HDC at a given temperature and output load during the FB discharge. In step 128, it is checked whether a value of the measuring discharge curve of the Field Battery is smaller than a value of the estimated Healthy Discharge Curve of the Field Battery at a distinct point of time. The check may be performed periodically during the measurements, e.g., for each measurement sample of the battery voltage, or for each nth measurement sample, where n may be a pre-defined value, after a pre-determined time span, or when a pre-determined voltage is reached. Other criteria may be applied. The point of time when the check is performed may define the point of time referred to as the distinct point of time in this disclosure. Algorithms may be defined, for when the check is determined to be finally positive. E.g., the data may be filtered, i.e. smoothed, e.g. over a time window, a number of subsequent checks may have to be positive to result in a finally positive check, or a threshold for the difference between the measured and predicted voltages or the difference between the distinct point of time and the predicted point of time when the voltage of the distinct point of time would have been expected according to the prediction by the estimated HDC may be defined. Other algorithms or criteria may be defined. The evaluation of the measured or determined discharge curve may also be performed afterwards, i.e. after a partial or complete discharge cycle of the Field Battery. In step 130, the time difference between the point of time where a battery voltage has been measured and a point of time where the same voltage has been estimated to be reached is determined. Graphically, this is the difference between the FBDC and the HDC along a horizontal line. The points of times may be the points of time of the check, including the "distinct" point of time, which is described above. However, any later point of time after the positive result of the check may be used. Alternatively, a measured voltage may be pre-determined at which the points of time and their difference are determined.

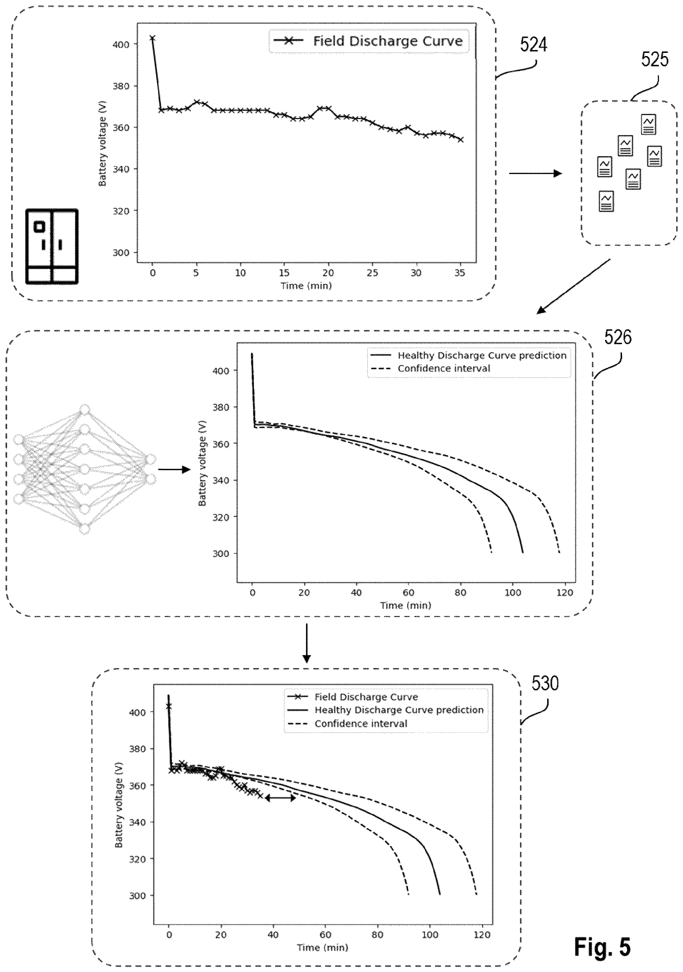

Fig. 5 illustrates the estimation 122 the SoH in an example. Corresponding to the step 124 of Fig. 1c, the battery is discharged, the battery voltage, temperature and output load are measured, and the field discharge curve is created in step 524 based on the battery voltage measurements. The battery voltage, temperature and output load are input 525 to the neural network, which predicts a Healthy Discharge Curve in 526 corresponding to step 126 of Fig. 1c. The Healthy Discharge Curve includes a confidence interval, depicted with dotted lines in the diagram at step 526. The diagram 530 corresponding to steps 128 and 130 of Fig. 1c illustrates the measured difference between the discharge curve of the Field Battery and the predicted Healthy discharge curve, including the confidence interval. The double-headed arrow indicates the difference between the distinct point of time on the FBDC and the corresponding point of time on the HDC with the same voltage. The determined difference is used for estimating the SoH. For example, the SoH is estimated to be the point of time where a voltage has been measured (on the FBDC; in minutes from starting the discharging) related to the predicted point of time (on the HDC, in minutes from starting the discharging) when the voltage should have been reached in case of a healthy battery under the same conditions.

Summarized, data regarding the discharge curves of the Reference Battery is collected. A limited number of discharges are performed by varying the temperature and the output load. This data is then processed by smoothing the curves with least squares smoothing and augmented with gaussian noise.

A neural network is trained on the data to predict the discharge curves of the Reference Battery, namely the Healthy Discharge Curves, given the temperature and output load as input parameters. The trained neural network will learn the relationship among temperature, output load and voltage, and it will be able to generalize and output the correct HDC given the load and temperature as input.

The predicted HDC represents the performance of the Field Battery with SoH 100%. Thus, given as input parameters to the trained neural network the actual load and temperature sustained by the Field Battery during a discharge, it is possible to compare the predicted HDC with the discharge curve of the Field Battery, namely the Field Discharge Curve, and based on their difference assess the SoH. The greater the discrepancy between FDC and HDC, the lower the SoH of the FB is estimated to be.

The algorithm can work on partial discharges of the Field Battery since, if the Field Battery is degraded, it is possible to observe a discrepancy between HDC and FDC early in the discharge process. The invention is both efficient and cost-effective, it can be adapted to various battery types, it reduces maintenance costs, and it estimates the SoH in a non-invasive way with basic sensors and limited experimental data requirements.

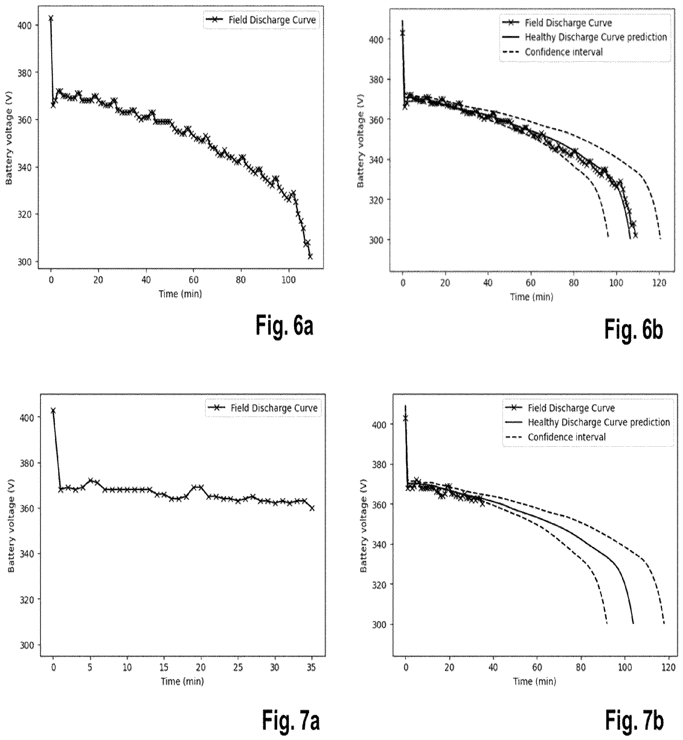

Figs. 6a, 7a, 8a and 9a show examples of field discharge curves and Figs. 6b, 7b, 8b and 9b show corresponding predicted healthy discharge curves including the confidence interval.

In particular, Figs. 6a and 6b show a complete discharge curve of the Field Battery, where the estimated SoH of the Field Battery is 100%. The field discharge curve follows the main line of the Healthy Discharge Curve as can be seen in Fig. 6b. No difference between the distinct point of time and the predicted point of time of the Healthy Discharge Curve has to be estimated. The SoH is determined to be 100%.

Figs. 7a and 7b show a partial discharge curve of the Field Battery, where the estimated SoH of the Field Battery is 100%. The field discharge curve follows again the main line of the Healthy Discharge Curve as can be seen in Fig. 7b. No difference between the distinct point of time and the predicted point of time of the Healthy Discharge Curve has to be estimated. The SoH is determined to be 100%.

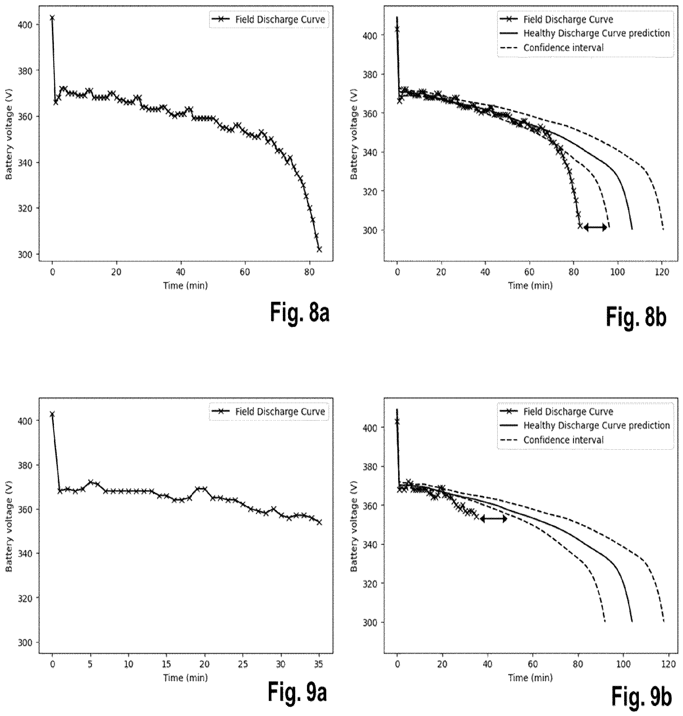

Figs. 8a and 8b show a complete discharge curve of the Field Battery, where the estimated SoH of the Field Battery is less than 100%. The field discharge curve deviates from the main line of the Healthy Discharge Curve and even leaves the confidential interval after ca. 80 minutes as can be seen in Fig. 8b. The difference between the distinct point of time and the predicted point of time of the Healthy Discharge Curve is estimated at the end of the measurement some minutes after leaving the confidential interval. The SoH is determined based on the estimated difference between the point of time of the last measurement and the point of time when this voltage should have been reached in case of 100% SoH, represented by the edge of the confidential interval of the predicted Healthy Discharge Curve. The percentage is determined by relating the distinct point of time to the predicted point of time. For example, if the distinct point of time is 60 minutes and the predicted point of time is 100 minutes, the SoH is estimated as 60 : 100 = 60%.

Figs. 9a and 9b show a partial discharge curve of the Field Battery, where the estimated SoH of the Field Battery is less than 100%. The field discharge curve deviates from the main line of the Healthy Discharge Curve and even leaves the confidential interval after ca. 20 minutes as can be seen in Fig. 9b. The difference between the distinct point of time and the predicted point of time of the Healthy Discharge Curve is estimated at the end of the measurement some minutes after leaving the confidential interval, which is about 20 minutes after starting the discharging. The SoH is determined based on the estimated difference between the point of time of the last measurement and the point of time when this voltage should have been reached in case of 100% SoH, represented by the edge of the confidential interval of the predicted Healthy Discharge Curve.

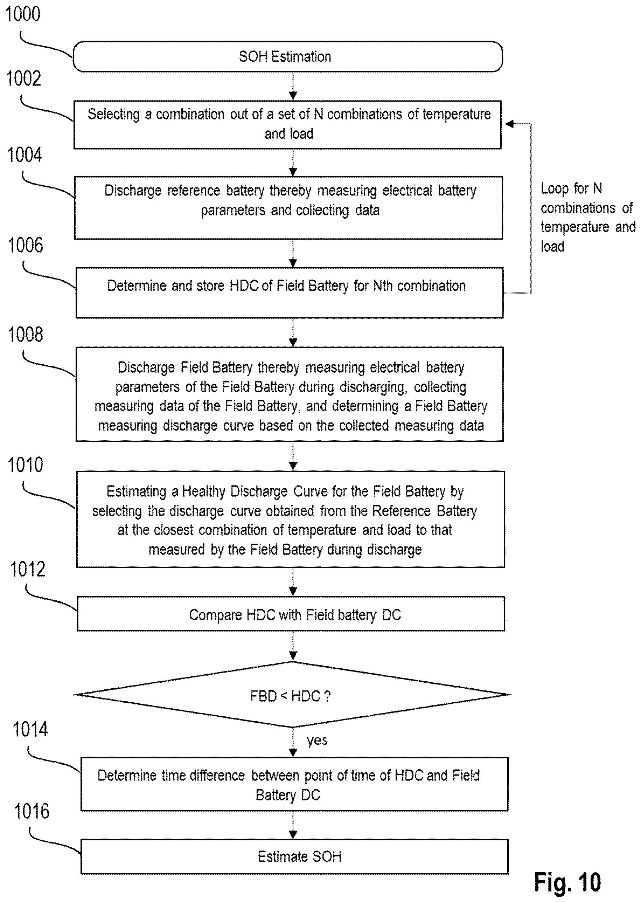

Fig. 10 shows an alternative method 1000 for estimating an SoH of a battery comprising the following steps:
In a first step 1002, a combination out of a set of N combinations of temperature and load at which a Reference Battery is to be discharged is selected. Then, a loop is performed that includes the following steps: In a first loop step 1002, a Reference Battery is discharged at the selected combination of temperature and load. In a second loop step 1004, electrical battery parameters of the Reference Battery are measured during discharging and the measuring data of the Reference Battery are collected. In a third loop step 1006, a Healthy Discharge Curve (HDC) of the Field Battery is determined from the collected measuring data of the Reference Battery and stored. These loop steps of the loop cycle are repeated for the remaining N-1 combinations. In a next step 1008 of the method, the Field Battery is discharged. During discharging, the electrical battery parameters of the Field Battery are measured, the measuring data of the Field Battery is collected, and a Field Battery measuring discharge curve is determined based on the collected measuring data. In step 1010, a Healthy Discharge Curve for the Field Battery is estimated by selecting the discharge curve obtained from the Reference Battery at the closest combination of temperature and load to that measured by the Field Battery during discharge. Then, in step 1012 of the method, the estimated Healthy Discharge Curve (HDC) of the Field Battery is compared with the measured discharge curve of the Field Battery. If a value of the measuring discharge curve of the Field Battery is smaller than a value of the estimated Healthy Discharge Curve of the Field Battery at a distinct point of time, in step 1014 the time difference between a point of time of the Field Battery Discharge Curve and a respective point of time according to the Healthy Discharge Curve is determined. In this context, "respective" means that at the two points of time the Discharge Curves show the same voltage. Finally, in step 1016, the SoH of the Field Battery is estimated based on the difference or relation between these two points of time.

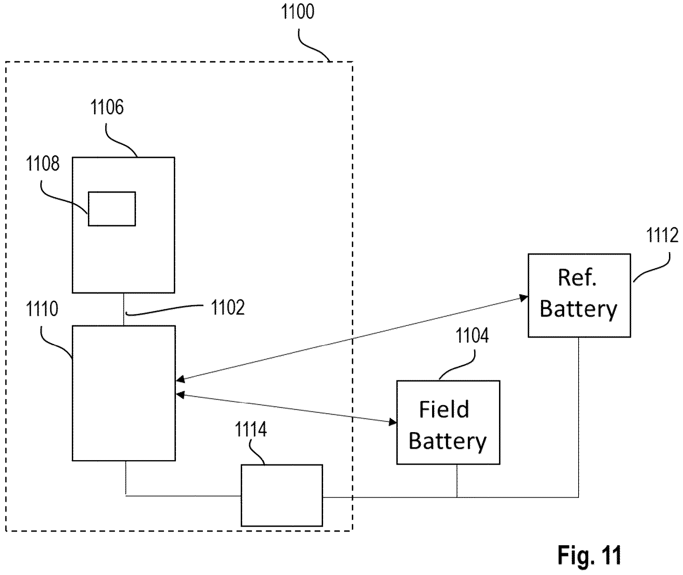

Fig. 11 shows a block diagram of an SoH estimating system 1100 comprising a data processing apparatus 1106 with means 1108 for carrying out the methods described herein. The means 1108 may be, for example, a processor or computer and a memory. It may also comprise communication units (not shown in Fig. 11) to communicate with other processing devices, e.g. a remote server, which may perform at least some of the steps of the methods described in this disclosure. The processing means 1108 may run a computer program comprising instructions which, when the program is executed by a processor or computer, cause the processor 1108 or computer 1108 to carry out one of the methods described herein. The memory is a computer-readable storage medium comprising instructions which, when executed by the processor 1108 or computer 1108, cause the processor 1108 or computer 1108 to carry out a method described in this disclosure.

The SoH estimating system 1100 further comprises an electrical battery parameter measuring interface 1102 configured to receive measurements of electrical battery parameters of a Field Battery 1104. The data processing apparatus 1106 is communicatively connected to the electrical battery parameter measuring interface 1102.

The SoH estimating system 1100 further comprises a measurement device 1110 configured to control the discharging of the Reference Battery 1112 or the Field Battery 1104 and / or to control the charging of the Reference Battery 1112 or the Field Battery 1104 and is configured to perform electrical battery parameter measurements of the Reference Battery 1112 during discharging and to perform electrical battery parameter measurements of the Field Battery 1104 during discharging.

The SoH estimating system 1100 further comprises a power device 1114 including a power source and/or a power sink configured to charge or discharge the Reference Battery 1112 and/or the Field Battery 1104. The power device 1114 may alternatively be external to the SoH estimating system 1100.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

## Claims

1. A method for estimating an SoH of a battery comprising the steps:
discharging a Field Battery;
measuring electrical battery parameters of the Field Battery during discharging, collecting measuring data of the Field Battery, and determining a Field Battery measuring discharge curve based on the collected measuring data;
estimating a Healthy Discharge Curve of Field Battery using a neural network trained with measuring data of electrical battery parameters of a Reference Battery collected during discharging a Reference Battery;
comparing (128) the estimated Healthy Discharge Curve of the Field Battery with the measuring discharge curve of the Field Battery;
if a value of the measuring discharge curve of the Field Battery is smaller than a value of the estimated Healthy Discharge Curve of the Field Battery at a distinct point of time, determining the time difference between the distinct point of time and a predicted point of time, when the value is estimated to be reached according to the prediction of the neural network;
estimating (130) an SoH of the Field Battery based on the difference between the distinct point of time and the predicted point of time.

2. The method according to claim 1, wherein the measuring data with which the neural network is trained comprises data of the following parameters:
Battery voltage,
environment temperature,
output load;
wherein the neural network has been trained by discharging sessions in which the environment temperature and/or the output load have been varied.

3. The method according to any of claims 1 or 2, wherein the Healthy Discharge Curve of the Field Battery and the measuring discharge curve each represent a battery voltage over time.

4. The method according to any one of the previous claims, wherein the Healthy Discharge Curve comprises a main curve and a confidence interval, and the predicted point of time is a point of time at the edge of the confidence interval.

5. A method for training a neural network configured to predict a Healthy Discharge Curve of battery comprising the steps:
obtaining training data during a plurality of discharges of a Reference Battery comprising battery voltage, temperature and output load; wherein temperature and output load are varied at each discharge;
training the neural network based on the training data to predict a Healthy Discharge Curve.

6. The method according to claim 5, wherein the measuring data is smoothed.

7. The method according to claim 5 or 6, wherein the number of discharges is artificially augmented by adding a noise voltage to the smoothed measuring data

8. A method (1000) for estimating an SoH of a battery comprising the steps:
selecting (1002) a combination out of a set of N combinations of temperature and load at which a Reference Battery is to be discharged;
performing a loop cycle with the steps:
discharging a Reference Battery at the selected combination and measuring (1004) electrical battery parameters of the Reference Battery during discharging and collecting measuring data of the Reference Battery;
determining and storing (1006) a Healthy Discharge Curve of Field Battery from the collected measuring data of the Reference Battery;
repeating the loop cycle for the remaining N-1 combinations;
discharging a Field Battery and measuring (1008) electrical battery parameters of the Field Battery during discharging, collecting measuring data of the Field Battery, and determining a Field Battery measuring discharge curve based on the collected measuring data;
estimating (1010) a Healthy Discharge Curve for the Field Battery by selecting the discharge curve obtained from the Reference Battery at the closest combination of temperature and load to that measured by the Field Battery during discharge;
comparing (1012) the estimated Healthy Discharge Curve of the Field Battery with the measured discharge curve of the Field Battery;
if a value of the measuring discharge curve of the Field Battery is smaller than a value of the estimated Healthy Discharge Curve of the Field Battery at a distinct point of time of the measurement,
determining (1014) the time difference between the distinct point of time and a point of time according to the Healthy Discharge Curve;
estimating (1016) an SoH of the Field Battery based on the difference between the distinct point of time and the point of time according to the Healthy Discharge Curve.

9. A data processing apparatus (1106) comprising means (1108) for carrying out a method of any one of claims 1-8.

10. A computer program comprising instructions which, when the program is executed by a computer, cause the computer to carry out a method of claims 1 to 8.

11. A computer-readable storage medium comprising instructions which, when executed by a computer, cause the computer to carry out a method of claims 1 to 8.

12. An SoH estimating system (1100) comprising
an electrical battery parameter measuring interface (1102) configured to receive measurements of electrical battery parameters of a Field Battery (1104); and
a data processing apparatus (1106) according to claim 9 when depending on claims 1 to 4, wherein the data processing apparatus is communicatively connected to the electrical battery parameter measuring interface (1102).

13. The SoH estimating system (1100) according to claim 12, further comprising a measurement device (1110) configured to
perform electrical battery parameter measurements of the Reference Battery (1112) during discharging; and to
perform electrical battery parameter measurements of the Field Battery (1104) during discharging.

14. The SoH estimating system (1100) according to claim 12 or 13, wherein the measurement device (1110) is further configured to
control the discharging of the Reference Battery (1112); and / or to
control the discharging of the Field Battery (1104).

15. The SoH estimating system (1100) according to any one of claims 12 to 14, further comprising a power device (1114) including a power source and/or a power sink configured to charge or discharge, respectively, the Reference Battery (1112) and/or the Field Battery (1104).
